# EUROPEAN PATENT APPLICATION

(11) **EP 0 623 964 A2**
(43) Date of publication of application: **09.11.1994**
(21) Application number: 94300140.4
(22) Date of filing: 10.01.1994
(51) Int. Cl.: H01L 29/784, H01L 29/788, H01L 29/792, H01L 21/322, H01L 21/265, H01L 27/115, H01L 21/306

(54) **Semiconductor devices using traps**

(30) Priority: 08.01.1993 US 2304
(71) Applicant: TEXAS INSTRUMENTS INCORPORATED, Dallas Texas 75265 (US)
(72) Inventor: Wills, Scott K., Houston, Texas 77072 (US); Depaolis, David D., Stafford, Texas 77477 (US)
(74) Representative: Abbott, David John

(57) **Abstract**

A method for fabricating a semiconductor device including providing a semiconductor device (8) having a substrate (10) and at least one semiconductor layer (12) thereon, damaging a portion of the semiconductor device thereby creating a plurality of trap sites (14) in the portion of the semiconductor device, and avoiding removing the trap sites during any further processing of the semiconductor device. The damaging step may be by injecting ions into a doped semiconductor region, reactive ion etching, ion bombardment or ion implantation at an energy of at least 120 KeV and atoms at least as large as arsenic. The damaged region may be one or more of a doped semiconductor region (12) or a conductive layer (16) insulatively disposed over a doped semiconductor region. The step of avoiding removing the trap sites includes avoiding annealing, flash-lamp annealing for less than 10 seconds, annealing at a temperature of less than 900°C for less than 30 minutes and forming a diffusion barrier of metal or silicon nitride over the damaged portion of the semiconductor device and diffusing hydrogen into the semiconductor device.

## Description

### TECHNICAL FIELD OF THE INVENTION

The present invention relates generally to semiconductor devices, and more particularly, to semiconductor devices that intentionally employ traps and methods for fabricating such semiconductor devices.

### BACKGROUND OF THE INVENTION

As semiconductor device sizes become increasingly small, some effects become more and more significant. One such effect is the hot hole and/or hot electron effect. Hot electrons are electrons which have sufficient energy to travel through oxides and the silicon substrate thereby damaging the material through which it travels. When these energetic electrons damage the materials in a transistor (or other semiconductor device) or become trapped in the gate oxide, the transistor (or semiconductor device) parameters are changed.

Hot holes result from the interaction of the mobile electrons in the material, or from the generation of hot electrons (current in opposite directions), with imperfections in the substrate or imperfections at the oxide/substrate interface. Such imperfections require the least energy for hot hole/electrons to change the transistor or semiconductor device characteristics, i.e., Vt. The smaller the transistor or semiconductor device, the more pronounced the effect. To minimize the effect, transistor structures are built in such a way that the junction is not abrupt. That is, the doping level of the junction changes as it approaches the gate edge of a transistor. A transistor with a graded junction is said to have a lightly doped drain (LDD) configuration.

To alter the doping profile of the junction, first the transistor is formed. That is, a polysilicon gate oxide stack is formed over the silicon substrate. Typically, an implant is done after this step to provide a light dopant level next to the gate edge which in subsequent heating steps will be driven in under the gate edge to make electrical contact with the electrically active area of the gate.

Next a sidewall oxide is formed as a spacer to force the subsequent implants away from the gate edge. Typically a heavy dopant level is implanted in the substrate to form the conductive region called a moat. The heavily implanted region may have more than one dopant with different diffusion constants to further grade the junction. During the anneal step, the implanted dopants in the moat diffuse under the sidewall oxide to complete the electrical connection to the gate.

Studies have shown that simply providing a graded junction is not enough to prevent the transistor from being degraded by hot carriers. The substrate must be free from defects known as trap sites, or the sites must be neutralized by the addition of hydrogen in the substrate. The hydrogen binds to the trap sites rendering them electrically inactive.

These and other disadvantages of the prior art are overcome by the present invention, however, and improved semiconductor devices that intentionally employ trap sites, as well as methods for fabricating such semiconductor devices, are provided.

### SUMMARY OF THE INVENTION

In a preferred embodiment, semiconductor devices are provided that intentionally employ trap sites, either in the substrate (at or near the face of the substrate) or in silicon dioxide or other semiconductor/dielectric layers located above the substrate. In addition, in preferred embodiments of the present invention, methods are provided for fabricating such semiconductor devices.

More particularly, the simplest semiconductor device of the present invention is a semiconductor device having an implanted region defined in the face of a body of semiconductor material and having a plurality of traps in a portion of this implanted region (also at or near the face of the semiconductor). A conductive layer (of semiconductor or metal) insulatingly abuts this implanted region and also abuts the plurality of traps. In this manner, the conductive layer may be used to provide varying strength electric fields to influence the interaction of charged carriers of current in the implanted region with the traps at the face of the semiconductor and thereby adjust the resistance of the implanted region, which may be, for example, a bus or bit line. Such a device is an edge-effect semiconductor device. In addition, the conductive layer may be extended to insulatingly overlay the implanted region and traps.

In an alternative preferred embodiment, an insulated gate field effect transistor device is provided that has source and drain regions defined in the face of a body of a semiconductor material and has a channel region therebetween. A plurality of traps are located at or near the face of the semiconductor in this channel region. A gate conductor, between the source and drain, is located near the face of the semiconductor over the channel but is insulated from the semiconductor by a gate insulator. The gate insulator and/or any sidewall oxide may also optionally contain trap sites at or near its interface with the body of semiconductor material. Such an insulated gate field-effect transistor device that intentionally employs a plurality of traps may be used as an electrically programmable memory device.

For other embodiments, additional layers of gate insulating material and conductors may be "stacked" upon the first gate structure to provide alternative structures also suitable for electrically programmable memory devices. Further, trap sites may also be optionally located in any gate oxide or other dielectric layer located at or above the face of the semiconductor material. In addition, sidewall oxides may be added to the sides of the initial gate. The sidewall oxides may optionally have traps at their interfaces with the substrate.

It is a feature of the present invention to provide semiconductor devices that intentionally employ traps to controllably alter the characteristics of such semiconductor devices.

It is also a feature of the present invention to provide methods for fabricating semiconductor devices that intentionally employ traps.

It is another feature of the present invention to provide edge-effect semiconductor devices that employ traps to controllably alter their operating characteristics.

It is yet another feature of the present invention to provide insulated gate field-effect transistor devices that intentionally employ traps to controllably alter the operating characteristics of such transistors.

These and other features and advantages of the present invention will become apparent from the following detailed description wherein reference is made to the figures in the accompanying drawings.

### BRIEF DESCRIPTION OF THE DRAWINGS

A more complete understanding of the present invention may be derived by referring to the detailed description and claims when considered in conjunction with the accompanying drawings in which like reference numbers indicate like features throughout the drawings, and wherein:
Figures 1, 2 and 3 are simplified cross-sectional views of an edge-effect semiconductor device according to the teachings of the present invention;
Figures 4, 5 and 6 are simplified cross-sectional views of an insulated gate field-effect transistor device made according to the teachings of the present invention and its operating modes;
Figures 7 and 8 are simplified characteristic curves for an NMOS transistor without and with trap sites, respectively;
Figure 9 is an enlarged portion of a tunnelling electron microscope picture of substrate damage indicative of trap sites in an NMOS transistor;
Figure 10 is a simplified cross-sectional view of a single gate structure, insulated gate field-effect transistor device with sidewall oxides made according to the teachings of the present invention;
Figure 11 is a simplified cross-sectional view of a two gate structure, insulated gate field-effect transistor device made according to the teachings of the present invention;
Figure 12 is a simplified cross-sectional view of a two gate structure, insulated gate field-effect transistor device with sidewall oxides made according to the teachings of the present invention;
Figure 13 is a simplified cross-sectional view of a two gate structure, insulated gate field-effect transistor device with sidewall oxides and a sidewall metallization layer made according to the teachings of the present invention;
Figure 14 is a simplified cross-sectional view of an insulated gate field-effect transistor device made according to the teachings of the present invention; and
Figure 15 is a simplified cross-sectional view of a fabrication step for creating trap sites in a semiconductor substrate according to the teachings of the present invention.

### DETAILED DESCRIPTION

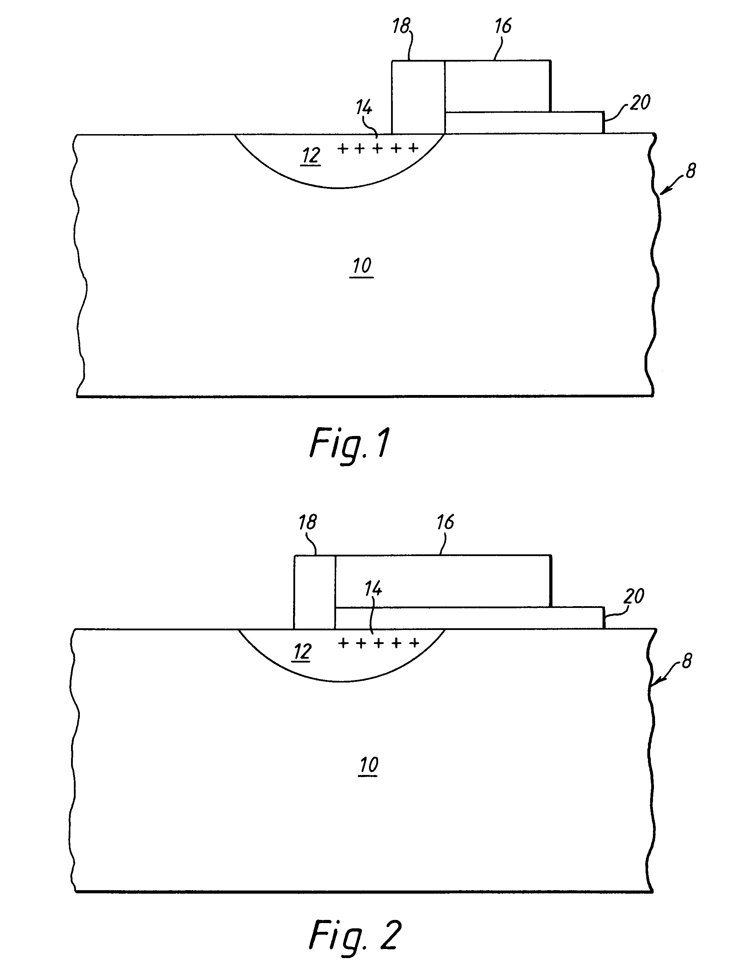

Referring now to Figure 1, there may be seen a cross-sectional view of an edge-effect semiconductor device 8 of the present invention. More particularly, it may be seen that there is a substrate of semiconductor material 10 in which there is an implanted region 12 that defines a "bus", a bit bar, or other line for allowing current to be passed from one area of the semiconductor substrate to a different area. In addition, there is depicted in Figure 1 a series of traps or trap sites 14, denoted by the "plus" signs, located at or near the face of the semiconductor in a portion of the implanted region 12. These traps 14, as noted later herein, are preferably formed either by implantation (using one or more different ions) or by an etching technique.

In general, it is known in the art that implantation and etching techniques may cause surface imperfections or traps. The present invention takes advantage of these known implantation or etching techniques to provide a suitable number of trap sites at or near the surface of the semiconductor device. It is currently believed that tens to hundreds, of such trap sites may be employed to controllably alter the operating characteristics of a semiconductor device. Such operative trap sites, regardless of their actual numbers, are referred to herein as a "plurality" of trap sites.

In addition, Figure 1 depicts a conductive layer 16 abutting a portion of the implanted region 12 that contains the traps 14. An optional sidewall oxide 18 is also shown, and may overlay a portion of the layer 16, but is only depicted overlaying a portion of the implanted region 12 and trap region 14. The conductive layer 16 is insulated from the substrate 10 by a dielectric layer 20, which may be a silicon dioxide layer. In this manner, the electric field generated by the conductive layer 16, which typically is polysilicon, will influence the charge carriers of current that are traveling through or along the implanted region 12 causing the trap site 14 fill density to be altered. In this manner, the resistance of a portion of the implanted region 12 may be modified to increase or decrease the resistance along the implanted region and thereby alter the current flow through the implanted region 12. Thus, region 12 in combination with the insulated conductive layer 16 may be characterized as a controllable analogue voltage source, or a line variable resistance. Such a line variable resistance may be employed to alter a circuit's RC constant and thereby alter the operating characteristics of such a circuit.

The optional sidewall oxide 18 of Figure 1 allows for more dispersion of the electric field to provide a broader scope of coverage over the implanted region 12 and accordingly cause more charge carriers of current to interact with the trap sites 14 located in the implanted region 12, and accordingly provide more control over the variation of the resistance characteristics of this implanted region 12 to these charge carriers. In addition, the sidewall oxide may also contain trap sites (not depicted in Figure 1 for ease of illustration purposes).

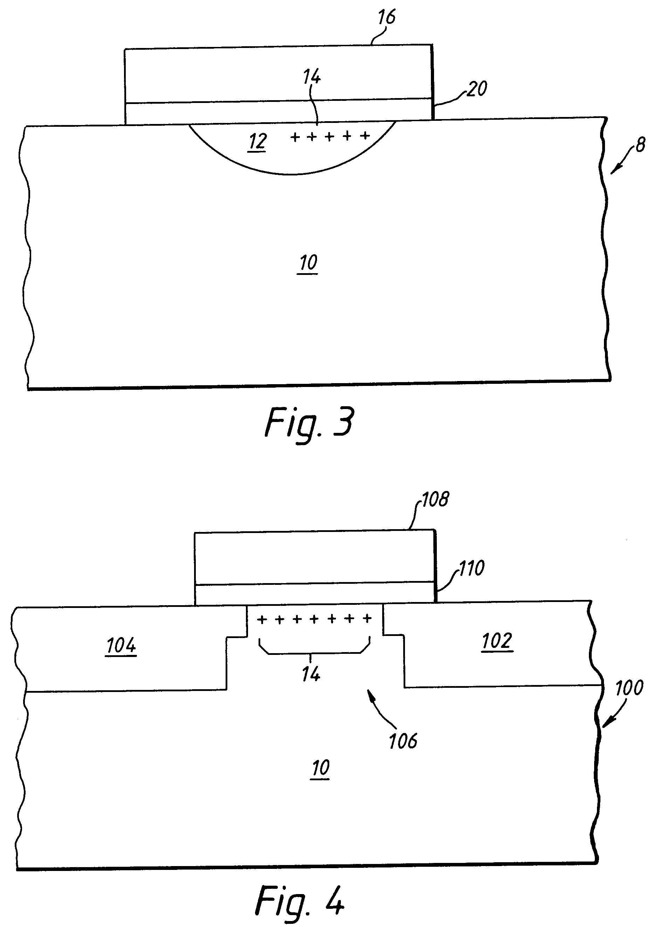

In accordance with the teachings of the present invention, the conductive layer 16 of Figure 1 may be continued, to insulatingly extend (as depicted in Figure 2) over some, substantially all, or (as depicted in Figure 3) all, of the implanted region 12. Thus, the conductive layer 16 may be adjacent (either abut or overlay) the implanted region 12. When the layer 16 extends over the entire implant region 12, then additional implant regions may be provided on either side of the layer to allow for the formation of an insulated gate field-effect transistor device.

Referring now to Figure 4, there may be seen a simplified cross-sectional depiction of such an insulated gate field-effect transistor semiconductor device 100. More particularly, it may be seen that there are source 102 and drain 104 regions defined in the face of a body of a semiconductor material 10 and that there is a channel 106 between the source 102 and the drain 104 regions. There are a plurality of traps 14 at or near the face of the semiconductor in this channel region 106. A gate 108 is depicted as extending between the source 102 and drain 104 regions on top of the face of the semiconductor 10 and this gate 108 covers this channel region 106 and is insulated from the semiconductor material by an appropriate gate insulator or dielectric 110. The gate 108 and dielectric 110 are analogous to the conductive layer 16 and dielectric 20, of Figures 1, 2 and 3. The gate conductor 108 is preferably a polysilicon layer. Although not depicted in Figure 4 for ease of illustration purposes, trap sites 14 may also optionally be located in the gate dielectric layer, 110 at or near its interface with the substrate. Typically, silicon dioxide is employed as a dielectric layer 110, but other layers may be so employed, such as, for example, but not limited to silicon nitride, or sandwiched layers of silicon nitride and dioxide.

In a similar manner trap sites may be employed in other circuit technologies, such as bipolar, to affect operating characteristics of transistors and other semiconductor devices. For bipolar, the traps are at the collector and emitter terminals and not "in" the transistor structure. These traps then alter the resistance at these terminals to affect the transistor's operation.

Thus, it may be seen that the present invention deliberately employs trap sites 14 in a portion of semiconductor material 10 or layers 110 associated therewith to alter the operating characteristics of semiconductor devices. That is, the present invention takes advantage of and utilizes any hot carriers (electrons or holes) and their interactions with trap sites. The present invention intentionally uses trap sites 14 in the area of the substrate 10 under the gate oxide 110, and optionally under any sidewall oxide, to create a memory device where the data state can be changed electrically and the retention of the data state is on the order of days to years. When employing the device 100 as a memory device, no refresh circuit is required, and no extra voltage levels are required beyond the normal operating voltage of the device 100, as described more fully later herein.

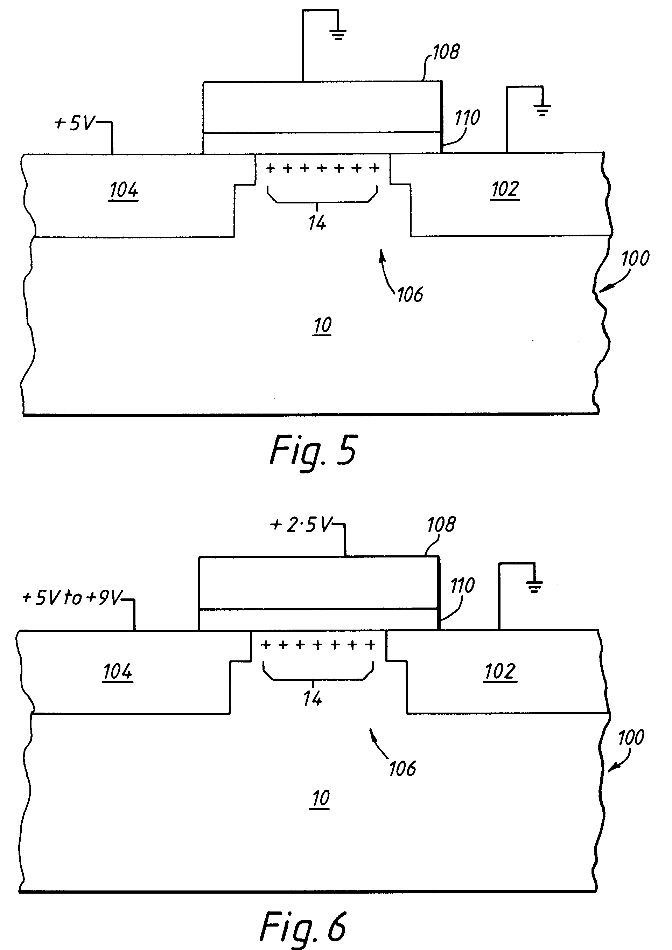

Accordingly, a preferred embodiment of the present invention is a memory device, such as an EPROM. The EPROM 100 of the present invention is simpler to fabricate than conventional EPROMS, because it preferably has only a single gate structure, and is simpler to operate than conventional EPROMS. The biasing conditions for the operation of the device 100 as an NMOS EPROM is depicted in Figures 4 and 5. Figure 4 depicts a "read" of the NMOS EPROM device, while Figure 5 depicts a "write" to the NMOS EPROM device.

Referring now to Figure 5, it may be seen that for the "read" operation of the NMOS device 100, a typical voltage of approximately 5 volts is applied across the drain 104 and source 102 of the device, while the gate 108 is grounded. If no current flows from source 102 to drain 104, then the logic state is a "zero". However, if current flows from source 102 to drain 104, then the logic state is a "one". Alternatively, the "one" and "zero" states may be reversed. Clearly voltages more or less than 5 volts may be so employed to "read" the device. For non-MOS devices, other voltages may be employed to operate alternative embodiments of the present invention.

Referring to Figure 6, a "write" operation may be seen. Typically, the gate 108 is held at approximately a positive 2.5 volts while a voltage of 5 to 9 volts is applied across the drain 104 and source 102. This biasing condition causes current flow under the gate dielectric 110 and positions charges at the dielectric/substrate interface that remain after the bias is removed. These charges prevent current flow during a subsequent read operation. The biasing condition is held for a few tenths of a second to about one second, depending on the magnitude of the source 104 to drain 102 voltage. That is, for about 9 volts, the condition is held for about one tenth of a second, while for about 5 volts, the condition is held for about one second. The specific voltages and timing may be easily determined for each type of device and will vary with the number, type and location of traps, as well as the other characteristics of the semiconductor layers and device. Thus, the NMOS EPROM device 100 of the present invention may employ normal MOS operating voltages, and does not require special higher voltages for reads and/or writes.

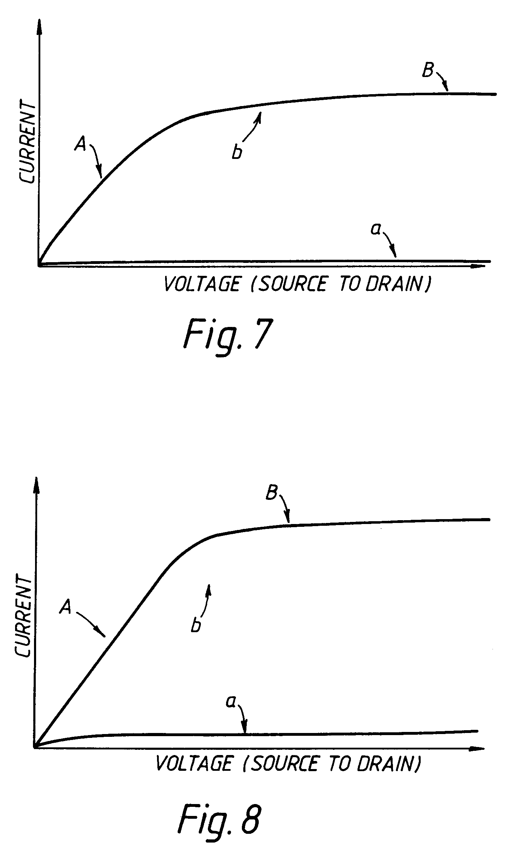

Referring now to Figure 7, typical operating curves a, b for an insulated gate NMOS field-effect transistor that does not employ traps 14 is depicted. As may be seen from Figure 7, operating curve a shows the current from drain 104 to source 102 to be 0 amperes for 0 volts gate bias. With a gate voltage above 0 volts there exists a portion A of the curve b where the transistor is not in saturation. The slope of the portion A is determined by the resistance of the transistor. However, portion B of curve b indicates saturation. The voltage at which the transistor saturates is dependent upon the size of the transistor, the mobile ion concentration, and the resistance of the transistor.

Referring now to Figure 8, typical operating curves a, b for an NMOS insulated gate field-effect transistor employing traps 14 is depicted. The slope of the portion A of curve a may be controlled by how many traps are activated. When the traps are activated, the NMOS transistor is now in depletion mode. As seen from curve a, at zero volts on the gate there is still some current flow through the transistor. An optional trap area in or under a sidewall may further modify the resistance of the transistor to modify the slope of region A.

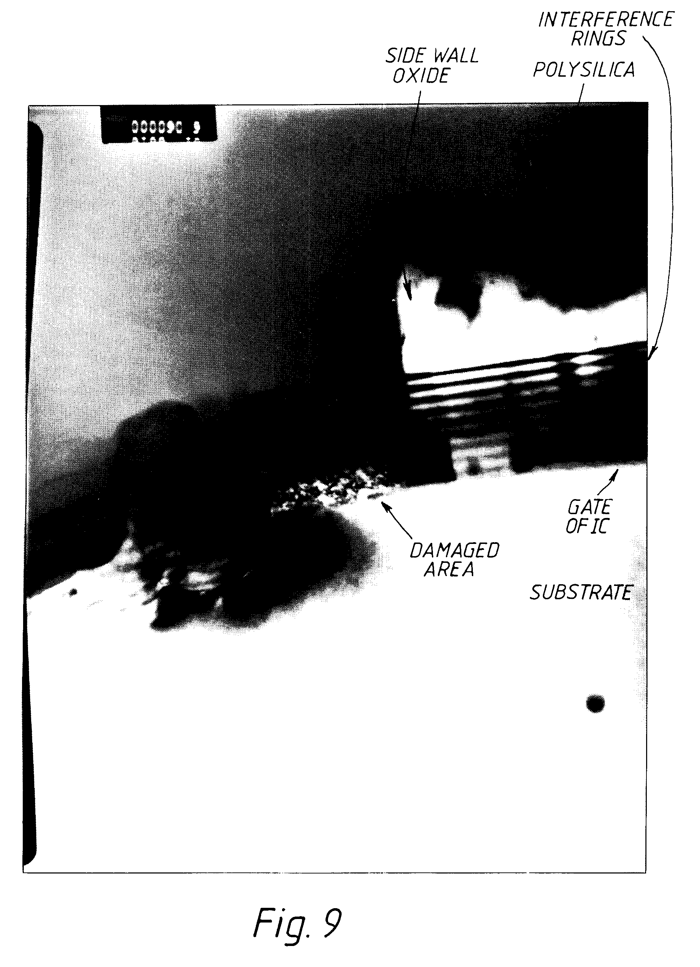

Referring now to Figure 9, there may be seen an enlarged portion of a tunnelling electron microscope picture of damaged silicon in the diffusion area located under the sidewall oxide of an insulated gate field-effect transistor. The damaged silicon appears as a granular looking area and represents those areas of silicon which contain trap sites. The gate silicon dioxide, polysilicon layer, and sidewall oxide, as well as the substrate, are also shown. Figure 9 also contains various artifacts and interference fringes.

Once "programmed" to contain a specific logic state, such a memory device may be "unprogrammed" by exposing the device to ultraviolet (uv) radiation (or other high energy photons, such as x-rays) or by "annealing" the device at temperatures above approximately 400° C for at least one hour.

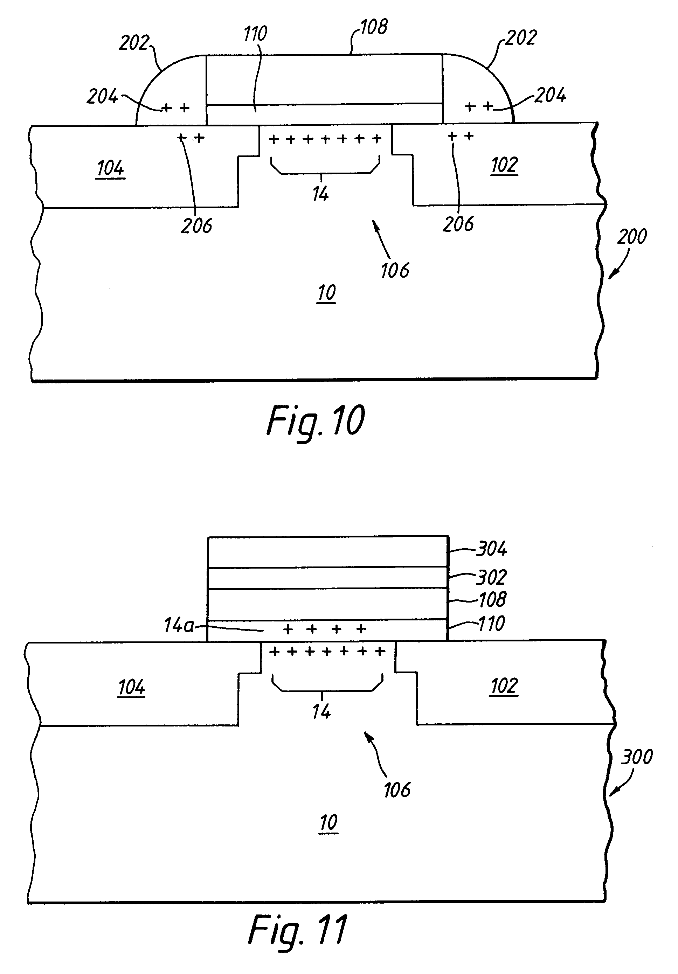

Referring now to Figure 10, there may be seen a cross-sectional depiction of an insulated gate field-effect transistor semiconductor device 200 that includes sidewall oxides. The sidewall oxide 202 optionally, may, or may not, have in the substrate 10, or in the oxide 202, at the oxide-substrate interface, electrically active trap sites 206, 204, respectively. If traps 206 are intentionally allowed to exist under the sidewall oxide 202 in the substrate 10, they are used to modify the gain of the transistor 200. More particularly, the traps in or under 204, 206 the sidewall oxide 202 effectively add additional "resistance" to the overall transistor 200 resistance and thereby lower the gain of the transistor 200. Without further enhancement to the transistor structure of Figures 4, 5 and 6 and Figure 10, the charge state of the traps may only be modified by either thermal energy or photons, such as light or x-rays, as noted earlier herein. Potentially, a reverse current through an interface having trap sites may help change the state of the charge at that interface.

The transistor structure of Figures 4, 5 and 6 may be modified by adding a programming gate structure over the first gate structure to provide the semiconductor device 300 depicted in Figure 11. This structure is similar to that used in a stacked EPROM cell. Referring now to Figure 11, there may be seen an additional gate structure of a dielectric layer 302 and conductive layer 304 on top of the gate structure of Figures 4, 5 and 6. In addition, traps 14a are depicted in dielectric layer 110. In a similar manner, traps may also be disposed in the upper dielectric layer 302, if desired.

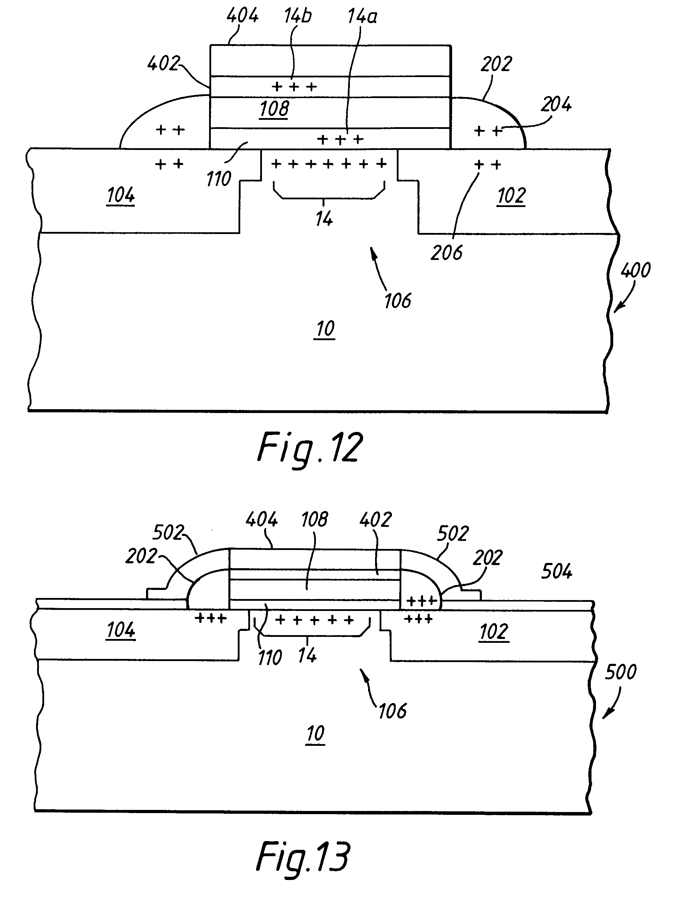

In addition, the structure of the transistor depicted in Figure 10 may be similarly modified to provide the semiconductor device 400 depicted in Figure 12 by also adding a programming gate structure 402, 404 over the first gate structure 108, 110. As illustrated in Figure 12, traps 14a, 14b may be located in either or both of dielectric layers 110, 402, respectively, as well as in or below the sidewall oxide 204, 206, respectively.

As depicted in Figure 13, conductive material 502 may be placed over the sidewall oxide 202 area of the transistor of Figure 12 to provide semiconductor device 500. The addition of this extra material 502 acts like another gate. In this way, the charge at the interface between the sidewall 202 and the substrate 10 may be appropriately controlled. More particularly, this in effect places two transistors along side and next to the "center" transistor having the double gate structure. An additional dielectric layer 504 insulates the conductive layer 502 from the substrate 10. Although not depicted, a dielectric wedge or layer may also insulate layer 502 from layer 404.

Dielectric layer 504 may be a continuation of sidewall oxide 202. Similarly, conductive layer 502 may be a continuation of conductive layer 404. Again, trap sites may be located in layer 110 and/or layer 402 and/or in or under the sidewall oxide 202.

Since the semiconductor devices of the present invention deliberately employ traps, those process or fabrication steps that would normally be employed to remove traps by annealing and the addition of hydrogen must be avoided for these special semiconductor devices. More particularly, a metal covering for the entire structure of the semiconductor device of the present invention may be used as a diffusion block for any hydrogen which is diffused into the substrate to control junction leakage in transistors which are to be of high quality, have no junction leakage, have no hot carrier effects and be stable over time. That is, a guard ring may be placed around the semiconductor device of the present invention (that deliberately employs trap sites) and a suitable metal covering placed over that guard ring whenever the remaining devices on the substrate are hydrogen annealed to eliminate traps. Preferably the semiconductor devices of the present invention are fabricated near the end of the production process to avoid unnecessary thermal and/or annealing cycles.

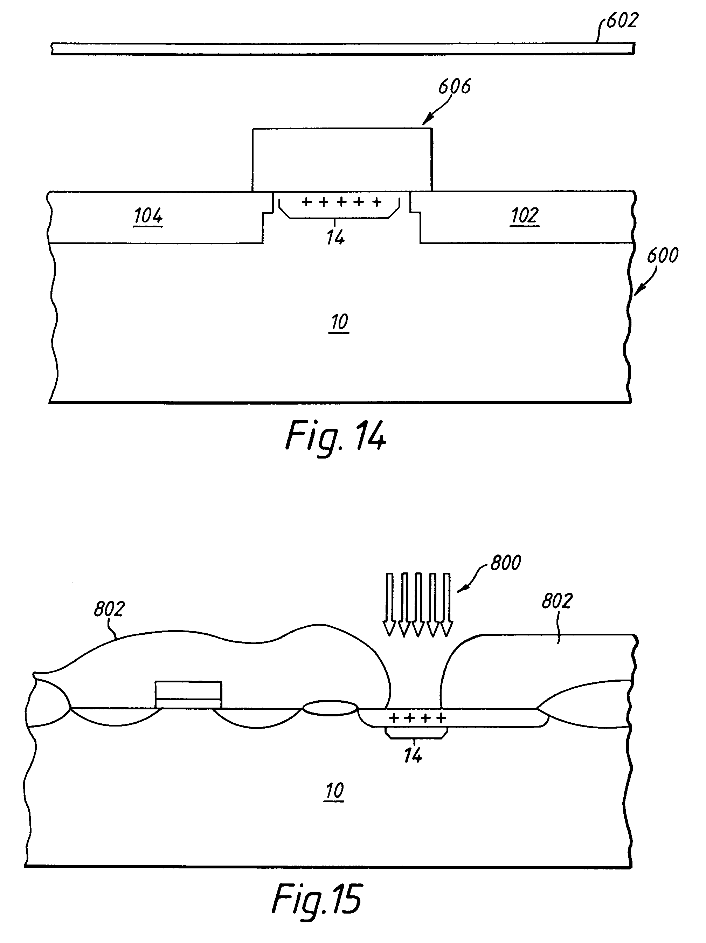

Referring now to Figure 14, there may be seen a device 600 that employs a metal layer 602 spaced from the substrate 10 and gate structure 606 by a spacer ring or layer (not depicted in Figure 14 for ease of illustration purposes). The gate structure 606 may be any one of the structures depicted in Figures 4, 5 and 6, or Figures 10-13. The metal layer 602 covers the entire device 600 structure and acts as a diffusion block for any hydrogen diffused into the chip to control junction leakage in transistors not employing trap sites.

Any means of leaving traps on or near the surface of a semiconductor material or in a layer will provide sufficient traps to control the gate charge. Typical means of generating traps would be to ion implant at high energies, e.g., 120 KeV or greater, and ion implantation with large atoms such as arsenic or larger. High energy x-rays may also be employed.

Figure 15 depicts such an ion implantation step. The arrows 800 depict the ions bombarding the exposed face of substrate 10 to create the trap sites 14. The remainder of the device on the substrate 10 is blanketed by an appropriate layer 802, such as photoresist or a low temperature layer (such as from a TEOS process) to prevent any ion damage, except for the "window" in this layer 802 where the device of the present invention will be located. The device of the present invention is then fabricated over this face with its active trap sites by known techniques. From wafer start to the first and/or second gate level, fabrication would follow standard process flows, for both the conventional devices blanketed by layer 802 and the devices of the present invention after trap site formation.

In addition, ion implantation with iron or other atoms which have donor electron or hole states may also be employed. Implanting with iron is typically not done on CMOS devices because the extra states cause leakage at the junctions. Another way to fabricate trap sites is to plasma etch the substrate in a mode which roughens the substrate. One such mode is a reactive ion etch (RIE) for which the device is on the plate to which RF power is applied, gas pressures are low (less than about 300 milliTorr) and powers are high (greater than about 5 watts/in²). Other alternate ways to generate trap sites would be to employ a well-masked x-ray beam or an ion beam mill.

Thermal oxide gates may be employed, but the effects of the intentional traps must not be removed. Optionally, low temperature tetraethyl orthosilicate (TEOS) oxide gates may be used instead of the normal thermal oxide gate. TEOS gates may be structured to have a normal thermal oxide on top of the TEOS. The TEOS gate may be structured to have a nitride over the top of its gate.

Any anneal processes for semiconductor devices with intentional traps should be brief. Specifically, flash-lamp anneals (10 seconds or less), laser-scanned anneals, or low-temperature (less than 900°C) anneals for brief times (less than 30-minutes) will prevent the traps from being annealed out. Further, any hydrogen introduced into the device to stabilize the non-trapped transistors should not be allowed to diffuse into the region of any devices that employ trap cells. To prevent this, metal can be employed to inhibit the diffusion of hydrogen into the substrate. Alternatively, thick pads of semiconductor, such as for example, silicon nitride, may be employed; the thickness should be sufficient to inhibit diffusion of hydrogen therethrough during the time of the "annealing" step. A guard ring should be placed around the area of the semiconductor device employing the techniques of the present invention and should be potentially electrically active at the time of any hydrogen diffusion.

As noted hereinbefore, the insulated gate field-effect transistor device of the present invention may be employed as an electrically programmable memory device, i.e., an EPROM cell. In addition, the semiconductor devices of the present invention may be employed as analog memory devices. That is, these memory devices may have any value or state between (and including) off to fully programmed. In addition, the devices of the present invention may be used as an analog current supply for analog logic in a microprocessor. Further, a true neural network memory cell for use with "fuzzy" logic may also be fabricated according to the teachings of the present invention.

When this invention is used in fuzzy logic, one possibility is to start with the device in an unprogrammed state. Forward programming would be applied to the gate 108 while backward programming would be applied to conductive layer 502 of Figure 13 and line variable resistance, as depicted in Figures 1, 2 and 3. A sea of such gates and variable resistances would then be interconnected to form a fuzzy logic cell or neural net.

Many other variations and modifications may be made in the techniques and apparatus hereinabove described, by those having expertise in this technology, without departing from the concepts of the present invention. Accordingly, it should be clearly understood that the methods and apparatus depicted in the accompanying drawings and referred to in the foregoing description are illustrative only and are not intended as limitations on the scope of the invention.

## Claims

1. A method for fabricating a semiconductor device, comprising:
providing a semiconductor device having a substrate and at least one semiconductor layer thereon,
damaging a portion of said semiconductor device thereby creating a plurality of trap sites in said portion of said semiconductor device, and
avoiding removing said trap sites during any further processing of said semiconductor device.

2. The method of claim 1, wherein:
said step of damaging said portion of said semiconductor device thereby creating a plurality of trap sites comprises injecting ions into a doped semiconductor region.

3. The method of claim 1, wherein:
said step of damaging said portion of said semiconductor device thereby creating a plurality of trap sites comprises reactive ion etching.

4. The method of claim 1, wherein:
said step of damaging said portion of said semiconductor device thereby creating a plurality of trap sites comprises ion bombardment.

5. The method of claim 1, wherein:
said step of damaging said portion of said semiconductor device thereby by creating a plurality of trap sites comprises implanting ions at an energy of at least 120 KeV and atoms at least as large as arsenic.

6. The method of claim 1, wherein:
said step of providing a semiconductor device includes providing a doped semiconductor region, and
said step of damaging said portion of said semiconductor device thereby creating a plurality of trap sites comprises damaging said doped semiconductor region.

7. The method of claim 1, wherein:
said step of providing a semiconductor device includes providing a conductive layer insulatively disposed over at least a portion of a doped semiconductor region, and
said step of damaging said portion of said semiconductor device thereby creating a plurality of trap sites comprises damaging said conductive layer.

8. The method of claim 1, wherein:
said step of providing a semiconductor device includes providing a conductive layer insulatively disposed over at least a portion of a doped semiconductor region, and
said step of damaging said portion of said semiconductor device thereby creating a plurality of trap sites comprises damaging said doped semiconductor region and said conductive layer.

9. The method of any preceding claim, wherein:
said step of avoiding removing said trap sites during any further processing of said semiconductor device includes avoiding annealing.

10. The method of any of claims 1 to 8, wherein:
said step of avoiding removing said trap sites during any further processing of said semiconductor device includes flash-lamp annealing for less than 10 seconds.

11. The method of claim 10, wherein:
said step of avoiding removing said trap sites during any further processing of said semiconductor device includes annealing at a temperature of less than 900°C for less than 30 minutes.

12. The method of claim 10 or claim 1, wherein:
said step of avoiding removing said trap sites during any further processing of said semiconductor device includes forming a diffusion barrier over said damaged portion of said semiconductor device and diffusing hydrogen into said semiconductor device.

13. The method of claim 12, wherein:
said step of forming a diffusion barrier over said damaged portion of said semiconductor device includes forming a metal layer over said damaged portion of said semiconductor device.

14. The method of claim 12, wherein:
said step of forming a diffusion barrier over said damaged portion of said semiconductor device includes forming a layer of silicon nitride over said damaged portion of said semiconductor device having a thickness sufficient to inhibit diffusion of hydrogen therethrough.

15. A method for fabricating a semiconductor device, comprising:
providing a semiconductor substrate;
forming at least one doped semiconductor region in a face of said semiconductor substrate;
forming an insulating layer over at least a portion of said at least one doped semiconductor region;
forming a conductive layer over said insulating layer;
damaging a portion of said semiconductor device thereby creating a plurality of trap sites in said portion of said semiconductor device, and
avoiding removing said trap sites during any further processing of said semiconductor device.

16. The method of claim 15, wherein:
said step of forming an insulating layer includes forming a silicon dioxide layer.

17. The method of claim 15, wherein:
said step of forming an insulating layer includes forming a low temperature orthosilicate oxide layer.

18. The method of any of claims 15 to 18, wherein:
said step of forming a conductive layer includes forming a polysilicon layer.

19. The method of any of claims 15 to 18, wherein:
said step of damaging a portion of said semiconductor device thereby creating a plurality of trap sites comprised damaging said portion of said at least one doped semiconductor region.

20. The method of any of claims 15 to 18, wherein:
said step of damaging a portion of said semiconductor device thereby creating a plurality of trap sites comprised damaging said conductive layer.

21. The method of any of claims 15 to 18, wherein:
said step of damaging a portion of said semiconductor device thereby creating a plurality of trap sites comprised damaging said portion of said at least one doped semiconductor region and said conductive layer.
